# EUROPEAN PATENT APPLICATION

(11) **EP 1 309 000 A2**
(43) Date of publication of application: **07.05.2003**
(21) Application number: 02024479.4
(22) Date of filing: 30.10.2002
(51) Int. Cl.: H01L 21/768

(54) **Via formation in polymers**

(30) Priority: 30.10.2001 US 16693
(71) Applicant: TRW INC., Redondo Beach, CA 90278 (US)
(72) Inventor: Lammert, Michael D., CA 90266 (US)
(74) Representative: Schmidt, Steffen J., Dipl.-Ing.

(57) **Abstract**

A method for forming relatively small vias in polymers which may have an underlying, dielectric layer, for example, silicon dioxide or silicon nitride layer is disclosed. Two embodiments of the invention are disclosed. In a first embodiment (FIGS. 1-15), plated pillars (34, 36) are formed on a plated bottom metal layer (26). A polymer (40) is then coated over the first metal layer (26) and the plated pillars (34, 36) and cured. The polymer (40) is blanket etched to expose the top surface of the plated pillars (34, 36). A metal layer (44) is formed on top of the polymer layer (44) and exposed surfaces of the plated pillars (34, 36). In a second embodiment of the invention (FIGS. 6-10), pillars (56, 58)made from a photoresist are formed over a bottom metal layer (52). After the photoresist pillars (56, 58) are formed, a polymer layer (60) is coated over the pillars (56, 58) and the bottom metal layer (52) and blanket etched to the surface of the photoresist pillars (56, 58). The photoresist pillars (56, 58) are then removed, for example, by O₂ plasma, forming vias. A top metal layer (60) is formed on top of the polymer coating (60) in the vias to connect to the bottom metal layer (52). Both methods in accordance with the present invention provide relatively small vias in polymers and are compatible with semiconductors which include an underlying dielectric layer, such as a silicon dioxide or silicon nitride layer, under the polymer.

## Description

### Background of the Invention

### 1. Field of the Invention

The present invention relates to semiconductor processing and more particularly to a method for forming vias in polymers.

### 2. Description of the Prior Art

There is an ever increasing trend to improve the operating speed of microelectronic semiconductor devices. In order to keep up with this trend, heterojunction bipolar transistor (HBT) devices based upon GaAs and InP technology have been developed. Examples of such devices are disclosed in commonly-owned U.S. Patent Nos. 5,352,911; 5,486,483; 5,804,487 and 5,994,194, hereby incorporated by reference. Such devices are known to include multilevel metal layers separated by a dielectric. In order to increase the operating speed of such devices, relatively thick layers of insulating materials with relatively low dielectric constants have been used between the metal layers. Use of an insulating layer with a lower dielectric constant reduces the capacitive coupling and minimizes cross talk between adjacent metal layers. Various silicon-based polymers, such as benzocyclobutene, manufactured by Dow Chemicals under the trade name Cyclotene™, and polynorbomene, manufactured by BF Goodrich under the trade name Avatrel™, are known to be used in semiconductor devices with operating speeds > 1GHz.

Methods are known for forming vias in polymers. Examples of these methods are disclosed in: "Reactive Ion Etching of Silicon Containing Polynorbornenes," by Qiang Zhao and Paul A. Kohl, Chemical Engineering, Georgia Institute of Technology, pages 1-30; and "Anisotropic Plasma Etching of Polymers Using a Cryo-Cooled Resist Mask," Schuppert, et al. J. Vac. Technol. A 18(2), March - April 2000, pages 385-387.

The first mentioned article discloses a method for a direct etch of polymers using a hard mask and dry etch chemistry of O₂ plus one or more fluorine containing etch gases, such as SF₆, CF₄, CHF₃ or NF₃. With an optimized etch chemistry favoring higher ratios of fluorine to oxygen, vias can be etched with about 30% to 50% under cut of the hard mask relative to the etch depth.

The second mentioned article discloses the use of similar etch chemistries, as discussed above, to achieve about 50% horizontal to vertical etch. However, the selectivity of the photoresist etched to the polymer is only 1:1 at best.

Unfortunately, neither of the etch processes discussed above are compatible with process technologies with non-uniform polymer layers or an application that uses a dielectric under the polymer. Thus, although a 30% to 50% undercut of an etch mask, i.e. 3:1 to a 2:1 anistrophic etch, is acceptable for some process applications, such results are achievable only in uniform thickness polymer layers that are placed over a material that will not be severely undercut by the oxygen/fluorine etch chemistries during the etch.

In practical applications, the polymer is known to be coated over a conventional dielectric, such as silicon dioxide or silicon nitride, on a wafer with metal layers and other topology that results in a polymer thickness that varies by 50% - 100% over the wafer, especially if the polymer tends to planarize during curing. Such practical applications result in various problems. For example, in regions where the polymer is thin, the polymer may be over-etched by 100% or more while etching the thicker polymer regions. In addition, if there is an underlying silicon dioxide or silicon nitride layer, the use of an etchant gas mixture with a larger fluorine to oxygen ratio is prevented since the silicon dioxide or silicon nitride layer will be severely undercut during the over-etch of the polymer in the areas where the polymers are thinner. In order to etch polymers with varying thickness without undercutting the silicon dioxide or silicon nitride layer, a lower fluorine to oxygen ratio in the etchant gas mixture can be used. However, such a mixture results in nearly an isotropic etch of the via, which results in relatively large vias for thicker polymer layers. A larger via size is not compatible with the original goal of adding the polymer in order to maintain small geometry metal lines to reduce the propagation delay. Accordingly, a need exists for a method for forming relatively small vias in thick polymer layers for practical applications using polymers in high speed circuit manufacturing.

### Summary of the Invention

Briefly, the present invention relates to a method for forming relatively small vias in polymers which may have an underlying dielectric layer, for example, silicon dioxide or silicon nitride layer. Two embodiments of the invention are disclosed. In a first embodiment, plated pillars are formed on a plated bottom metal layer. A polymer is then coated over the first metal layer and the plated pillars and cured. The polymer is blanket etched to expose the top surface of the plated pillars. A metal layer is formed on top of the polymer layer and exposed surfaces of the plated pillars. In a second embodiment of the invention, pillars made from a photoresist are formed over a bottom metal layer. After the photoresist pillars are formed, a polymer layer is coated over the pillars and the bottom metal layer and blanket etched to the surface of the photoresist pillar. The photoresist pillars are then removed, for example, by O₂ plasma, forming vias. A top metal layer is formed on top of the polymer coating in the vias to connect to the bottom metal layer. Both methods in accordance with the present invention provide relatively small vias in polymers and are compatible with semiconductors which include an underlying dielectric layer, such as a silicon dioxide or silicon nitride layer, under the polymer.

### Description of the Drawings

These and other advantages of the present invention will be readily understood with reference to the following specification and attached drawings wherein:

FIGS. 1 and 2 are process diagrams which illustrate the formation of the plated pillars in accordance with a first embodiment of the invention.

FIG. 3A is a process diagram illustrating the coating of the plated pillars with a planarizing polymer in an application with an optional underlying dielectric layer.

FIG. 3B is similar to FIG. 3A but illustrates the use of a non-planarizing polymer in combination with a planarizing coating.

FIG. 4 is a process diagram illustrating the etching of the polymer coating in accordance with the first embodiment of the invention.

FIG. 5 is a process diagram illustrating the formation of a metal layer on top of the etched polymer coating and the plated pillars in accordance with the first embodiment of the invention.

FIG. 6 is a process diagram illustrating a second embodiment of the invention illustrating the formation of pillars formed from photoresist with an optional dielectric underlying layer.

FIG. 7A is a process diagram illustrating the coating of the photoresist pillars with a planarized polymer in accordance with the second embodiment of the invention.

FIG. 7B is similar to FIG. 7A but illustrates the combination of a non-planarized polymer along with a planarized coating.

FIG. 8 is a process diagram illustrating the etching of the polymer coating to expose the photoresist pillars.

FIG. 9 is a process diagram illustrating the removal of the photoresist pillars.

FIG. 10 is a process diagram illustrating the formation of a metal layer on top of the polymer layers and in the vias formed by removal of the photoresist pillars.

### Detailed Description

The present invention relates to a process for forming relatively small via holes in polymers, for example, silicon-based polymers with low dielectric constants as discussed above. Such polymers are typically used between two layers of metal lines to decrease the capacitance coupling and thus the propagation delay in order to improve the operating speed of the device. The process in accordance with the invention can be used in practical applications in which there is an underlying dielectric layer of, for example, silicon nitride or silicon dioxide. The process is compatible with various types of metal layers that may be used in integrated circuit manufacturing, such as Al, Au or Cu.

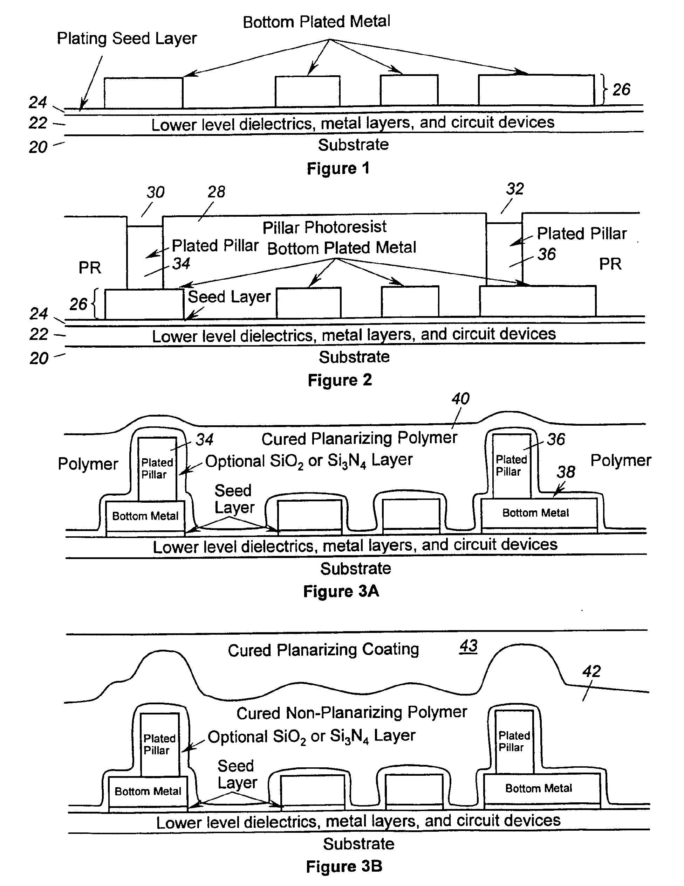

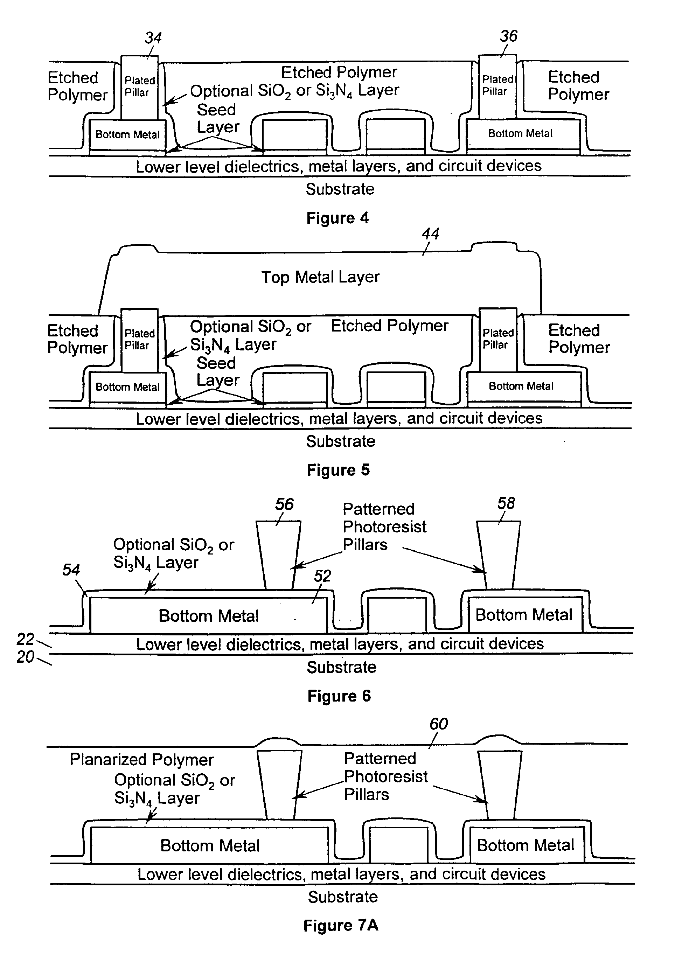

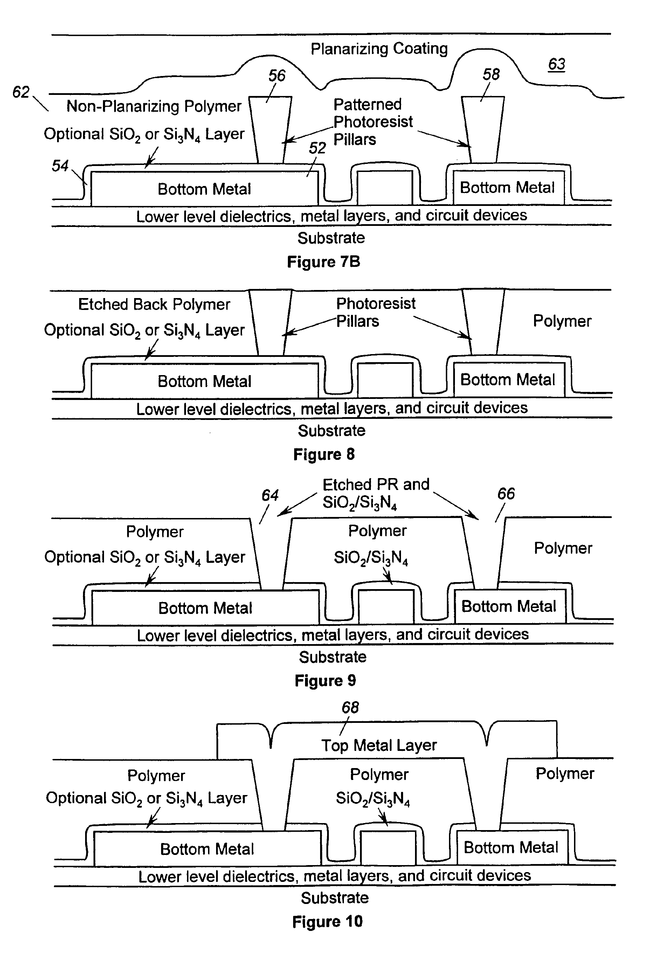

Two embodiments of the invention are disclosed. The first embodiment is illustrated in FIGS. 1-5. As will be discussed in more detail below in connection with FIGS. 3A and 3B, this embodiment can be used with both planarizing and non-planarizing polymer coatings. The second embodiment of the invention is illustrated in FIGS. 6-10. This embodiment can also be utilized with both planarizing and non-planarizing polymer coatings, as will be discussed in detail below in connection with FIGS. 7A and 7B.

Both embodiments of the present invention relate only to forming vias in polymers in semiconductor devices, for example, semiconductor devices based upon Si, GaAs or InP technology. The formation of lower level layer of dielectrics, metal and circuit devices on a substrate is outside of the scope of the present invention. Exemplary processes for forming such lower level dielectrics, metal layers and circuit devices on a substrate are known in the art are disclosed, for example, in commonly-owned U.S. Patent Nos. 5,352,911; 5,486,483; 5,804,487 and 5,994,194, hereby incorporated by reference.

Generally speaking, the first embodiment utilizes plated pillars formed on top of the bottom metal layer. The plated pillars are coated with a silicon-based polymer, such as benzocyclobutene and cured. The cured polymer coating is blanket etched to expose the top surface of the plated pillars. A metal layer is formed on top of the top surfaces of the plated pillars and the cured polymer coating.

Referring to FIG. 1, a Si, GaAs or InP substrate 20 is provided. A lower level layer comprising dielectrics, metal, and/or circuit devices, generally identified with the reference numeral 22, is formed on top of the substrate 20 by conventional techniques as discussed above. In accordance with one embodiment of the invention, a plating seed layer 24 is formed over the lower level metal and dielectric layers 22. The plating seed layer 24 may be used to form the first, second or any lower level interconnect layer of a multiple metal layer process. The plating seed layer 24 may be formed by evaporating or sputtering a thin metal layer, for example, 500 angstroms to 3000 angstroms thick, consisting of a metal adhesion layer, such as Ti, TiW, TiN or Cr plus a metal, such as Au or Cu, upon which another metal can be plated readily. This seed layer 24 serves as a continuous conducting metal film required for plating the lower metal layer 26. The lower metal layer 26 may be patterned by conventional techniques, such as photolithography, and then plated in a conventional manner to a thickness, for example, 1 to 4 micrometers.

Referring to FIG. 2, after the lower metal layer 26 is formed, any conventional photoresist 28, compatible with metal plating processes, is spun over the patterned bottom metal layer 26 and the seed layer 24. The photoresist layer 28 may be patterned by conventional techniques, such as photolithography, to form the patterned vias 30 and 32, for example. The photoresist layer 28 may be coated directly over the lower layer metal 26 and its resist or the lower layer metal resist may be first stripped and then the next layer of resist coated over the seed layer 24 and the lower layer metal 26. The vias 30 and 32 are plated, as discussed above, to form plated pillars 34 and 36 to height of, for example, 1 micrometer to 10 micrometers or more, using the same seed layer 24 as was used to plate the lower metal layer 26. The photoresist layer 28 is then stripped by conventional techniques. The seed layer 24 that is not under the lower layer metal 26 is then removed by wet chemical etching, a dry etch process or a combination of both.

As shown in FIGS. 3A and 3B, an optional dielectric coating 38, such as SiO₂ or Si₃N₄, for example, having a thickness 500 angstroms to 5000 angstroms or more, may be applied to the device before coating the device with a relatively thick polymer layer 40. Subsequently, as shown in FIG. 3A, the device may be coated with a planarizing polymer 40, such as benzocyclobutene. The thickness of the polymer 40 is selected to be approximately the sum of the height of the lower metal layer 26 and the height of the plated pillars 34 and 36. The polymer 40 is then cured at the manufacturer's recommended specifications.

If the polymer 40 forms a planarized layer after curing, the polymer film will flow to a height slightly above the height of the plated pillars 34 and 36, as generally shown in FIG. 3A. If a non-planarizing polymer 42 is used, such as polynorborene, as shown in FIG. 3B, a planarizing coating 43 is applied thereupon after curing the non-planarizing polymer 42, according to the manufacturer's recommended specifications as generally shown in FIG. 3B. The planarizing coating 40 is cured when required by the manufacturer's specifications.

The planarizing polymer 40 or the combination of the non-planarizing polymer 42 with the planarizing coating 43 is etched back, for example, with a dry etch using a combination of oxygen and fluorine containing gas, such as SF₆, CF₄, CHF₃ or NF₃, until, for example, the top, 1000 angstroms to 5000 angstroms of the plated pillars 34 and 36 are exposed. When the non-planarizing polymer 42 is used with a planarizing coating 43, the oxygen and fluorine containing gas mixture is adjusted to achieve a nearly equal etch rate for both the non-planarizing polymer 42 and the planarizing coating 43.

If the device is formed with the optional dielectric layer 38, this layer can be etched after the polymer layer 40 or combination of polymer layer 42 and coating 43 using a separate dry etch recipe as part of the initial polymer etch back or using a conventional wet etch to form the device as generally illustrated in FIG. 4.

As mentioned above, the top surfaces of the plated pillars 34 and 36 are exposed. A top metal layer 44 is formed to be in contact with these top surfaces. The top metal layer 44 may be formed by various conventional metallization techniques including evaporation and lift off or etch, sputter deposition and etch, or sputter deposition of a seed layer and plating to form the device as generally shown in FIG. 5.

If an evaporated metal is used for the top metal layer 44, better step coverage by this metal over the portion of the plated pillars 34 and 36 that extends beyond the polymer layer 40 can be achieved using a resist with a re-entrant profile to form the plated pillars 34 and 36. This profile can be achieved, for example, using a negative i-line resist or a NH₃ image reversal of a positive photoresist.

In order to form higher level vias, a plated metal layer may be used for the top metal layer 44. Plated pillars may then be formed on top of the plated metal layer 44, coated with a polymer, and cured and etched back as described above. A top metal layer can be formed on top of the plated pillars as discussed above. Additional metal layers can be formed in a similar manner.

A second embodiment is illustrated in FIG. 6-10. Similar to the first embodiment of the invention, this embodiment relates to forming vias in relatively thick polymers, as discussed above, on top of a substrate 20 and a lower level layer of dielectrics, metal and/or circuit devices, generally identified with the reference numeral 22. Generally speaking in this embodiment of the invention, photoresist pillars are formed on top of a bottom metal layer 52 with an optional dielectric layer, for example, SiO₂ or Si₃N₄. Once the photoresist pillars are formed, the device is coated with a thick polymer. The polymer is etched back to the top surface of the photoresist pillars. The photoresist pillars are then removed by conventional techniques forming relatively small vial. A metal layer is then formed on top of the polymer and fills in the vias and connects to the bottom metal layer.

Referring to FIG. 6, the bottom metal layer 52 is formed by any conventional metallization process, such as evaporation and lift off, evaporation or sputter deposition and etch, or by plating on a seed layer, as discussed above. An optional dielectric film layer 54 may be deposited over the bottom metal layer 52. A high temperature photoresist layer is formed over the dielectric layer 54. The high temperature photoresist layer should be selected so as not to flow significantly at nominal polymer cure temperatures. The photoresist is coated to a thickness of 1 micrometer to 10 micrometers over the lower metal layer 52 and patterned by conventional photolithography techniques to form the photoresist pillars 56 and 58. Although vertical photoresist sidewalls are acceptable in the patterned pillars 56 and 58, a negative i-line or NH₃ image reversal of a photoresist may be used to achieve a slightly re-entrant sidewall, as generally shown in FIG. 6.

A silicon-containing polymer or other polymer 60 as discussed above, that will not etch significantly in an O₂ plasma, is coated over the bottom metal layer 54 to a thickness approximately equal to the sum of the height of the bottom metal layer 52 and the height of the photoresist pillars 56 and 58. If the solvent system used in the polymer also tends to dissolve the photoresist pillars, the photoresist may be hardened by an extended thermal bake, a deep UV exposure, an electron flood exposure or other hardening technique prior to the coating of the polymer 60. The polymer 60 is cured using a thermal cycle that does not cause significant flow or distortion of the photoresist pillars 56 and 58.

Similar to the embodiment illustrated in FIGS. 1-5, both a planarizing polymer and a combination of a non-planarizing polymer with planarizing coating can be used. FIG. 7A illustrates the use of a planarizing polymer. The planarizing polymer 60 is cured using the manufacturer's specification and forms a generally planar surface over the bottom metal layer 52 and optional dielectric layer 54, as generally shown in FIG. 7A.

If a non-planarizing polymer 62 is used, as generally shown in FIG. 7B, the non-planarizing polymer is cured using the manufacturer's specification and then coated with a planarizing coating 63 as illustrated in FIG. 7B. The planarizing coating 63 is then cured at the manufacturer's recommended specifications.

As shown in FIG. 8, the planarized polymer 60 or the combination non-planarized coating 62 with a planarized coating 63 is etched back using a dry etch procedure, using a mixture of oxygen in one or more fluorine containing gases, such as CHF₃, CF₄, SF₆ or NF_{3,} until the top of the photoresist pillars 56, 58 is exposed, as generally shown in FIG. 8. The photoresist may then be etched in a O₂ plasma with a selectivity ≥ 10:1 to the Si containing polymer 60 or 62. If the optional dielectric layer 54 is deposited prior to the pillar resist formation, the dielectric layer 54 may be etched as a final step in the polymer and resist etch, as generally shown in FIG. 9 to form the vias 64 and 66. If the manufacturer's recommended cure temperature for the planarizing polymer or non-planarizing polymer exceeds the flow temperature of the patterned pillar resist, the planarizing polymer may be partially cured at a lower temperature, then fully cured after the etch of the pillar resist.

A top metal layer 68 is formed by any conventional metal process that will produce reasonable metal coverage into a small via, such as sputter deposition and etch or sputter deposition of a seed layer following patterning and plating of a top metal layer to form the structure illustrated in FIG. 10. Additional metal layers may be formed by repeating the steps above. The process is compatible with most if not all types of metal layers that may be used in integrated circuit manufacturing, such as Al, Au or Cu.

Obviously, many modifications and variations of the present invention are possible in light of the above teachings. Thus, it is to be understood that, within the scope of the appended claims, the invention may be practiced otherwise than as specifically described above.

What is desired to be secured by a Letters Patent is as follows:

## Claims

1. A process for forming vias in polymers with low dielectric constants, the process comprising the steps of:
(a) providing a substrate layer;
(b) forming a lower level layer of dielectric, metal and/or circuit devices on said substrate layer;
(c) forming a seed layer on top of said lower level layer;
(d) forming a lower metal layer on said seed layer;
(e) forming one or more plated pillars having top surfaces on said lower metal layer;
(f) removing the seed player not under the lower level layer;
(g) coating said one or more plated pillars and said seed layer with a low dielectric polymer;
(h) curing said polymer;
(i) exposing said top surfaces of said plated pillars; and
(j) forming a metal layer to contact said exposed top surfaces of said plated pillars.

2. The process as recited in claim 1, wherein said coating step comprises coating with a low dielectric planarizing polymer.

3. The process as recited in claim 1, wherein said coating step comprises coating with a low dielectric, non-planarizing polymer and forming a planarizing coating over said non-planarizing polymer.

4. The process as recited in claim 1, further including the step of applying a dielectric layer to said plated pillars and bottom metal layer.

5. The process as recited in claim 1, wherein the step of coating comprises coating said one or more plated pillars and said lower metal layer with a silicon-based polymer.

6. The process as recited in claim 5, wherein the step of coating said one or more plated pillars and said lower metal layer comprises coating with benzocyclobutene.

7. The process as recited in claim 5, wherein the step of coating said one or more plated pillars and said seed player comprises coating with polynorbornene.

8. A process for forming vias in polymers with low dielectric constants, the process comprising the steps of:
(a) providing a substrate layer;
(b) forming a lower level layer of dielectric, metal and/or circuit device on said substrate;
(c) forming a bottom metal layer on said lower level layer;
(d) forming one or more pillars from a photoresist on said lower metal layer;
(e) coating said one or more pillars with a polymer;
(f) curing said polymer;
(g) etching back said polymer to expose said photoresist pillars
(h) removing said one or more photoresist pillars to form vias; and
(i) forming a metal layer to contact said bottom metal layer on top of said polymer coating.

9. The process as recited in claim 8, further including the steps of:
(j) forming a dielectric on top of said bottom metal layer and said lower level layer before said coating step; and
(k) removing said dielectric layer from said bottom metal layer before said metal layer is formed on top of said polymer coating.

10. The process as recited in claim 8, wherein said coating step comprises coating with a low dielectric planarizing polymer.

11. The process as recited in claim 8, wherein said coating step comprises coating with a low dielectric, non-planarizing polymer and forming a planarizing coating over said non-planarizing polymer.

12. The process as recited in claim 8, wherein the step of coating comprises coating said one or more photoresist pillars with a silicon-based polymer.

13. The process as recited in claim 12, wherein the step of coating said one or more photoresist pillars comprises coating with benzocyclobutene.

14. The process as recited in claim 12, wherein the step of coating said one or more photoresist pillars comprises coating with polynorbornene.
